# FASCICULE DE BREVET EUROPEEN

(11) **EP 3 983 571 B1**
(45) Date de publication et mention de la délivrance du brevet: **12.07.2023**
(21) Numéro de dépôt: 20737235.0
(22) Date de dépôt: 14.05.2020
(51) Int. Cl.: C23C 14/34, C23C 14/06, H01J 37/32, C23C 14/35, H01J 37/34

(54) **PROCÉDÉ DE REVÊTEMENT D'UN SUBSTRAT PAR DU NITRURE DE TANTALE**
VERFAHREN ZUR BESCHICHTUNG EINES SUBSTRATES MIT TANTALNITRID
METHOD FOR COATING A SUBSTRATE WITH TANTALUM NITRIDE

(30) Priorité: 11.06.2019 FR 1906168
(43) Date de publication de la demande: 20.04.2022
(73) Titulaire: SAFRAN, 75015 Paris (FR); Centre national de la recherche scientifique, 75016 Paris (FR); UNIVERSITE DE BORDEAUX, 33000 Bordeaux (FR)
(72) Inventeur: CAVARROC, Marjorie, Christine, 77550 MOISSY-CRAMAYEL (FR); GIROIRE, Baptiste, Simon, 33000 BORDEAUX (FR); TEULE-GAY, Lionel, 33300 BORDEAUX (FR); POULON, Angélique, 33460 ARSAC (FR)
(74) Mandataire: Cabinet Beau de Loménie
(86) Numéro de dépôt international: PCT/FR2020/050801
(87) Numéro de publication internationale: WO 2020/249879

(56) Documents cités:
- EP-A1- 2 325 349
- WO-A1-2009/122378
- WO-A1-2014/154894
- WO-A1-2018/215410
- US-A- 6 110 598
- US-A1- 2004 055 881

## Description

### Domaine technique

L'invention concerne un procédé de revêtement d'un substrat par au moins une couche de nitrure de tantale, en vue de remplacer les revêtements à base de chrome au degré d'oxydation +VI.

### Technique antérieure

Afin d'améliorer les propriétés des substrats métalliques, notamment en termes de résistance à la corrosion ou à l'usure, il est connu de les recouvrir d'une couche protectrice. Les documents WO 2009/122378, US 2004/055881 etWO 2014/15489 décrivent des modes de préparation de telles couches protectrices. A ce titre, l'oxyde de chrome au degré d'oxydation +VI est particulièrement avantageux dans la mesure où il possède une bonne dureté, une résistance élevée à la fatigue et à la corrosion et également une bonne stabilité thermique et chimique. Néanmoins, dans le cadre de l'évolution législative et du règlement REACH, ces revêtements au chrome doivent être remplacés. Il est donc nécessaire de disposer de solutions de remplacement ayant des propriétés physico-chimiques au moins équivalentes et compatibles des exigences industrielles, économiques et environnementales.

### Exposé de l'invention

L'invention concerne un procédé de revêtement d'un substrat par du nitrure de tantale par technique de pulvérisation cathodique magnétron pulsé à haute puissance, dans lequel on utilise une cible de tantale et dans lequel le revêtement du substrat est effectué sous atmosphère contenant de l'azote, la polarisation de la cible étant contrôlée durant le revêtement en imposant à celle-ci la superposition d'une polarisation continue à un potentiel compris entre -300 V et -100 V et d'une polarisation pulsée dont les pulses sont à un potentiel compris entre -1200 V et -400 V.

L'invention repose sur l'emploi d'une technique de pulvérisation cathodique magnétron pulsé à haute puissance (désignée par l'acronyme « HiPIMS » dans la littérature en langue anglaise pour « High-Power Impulse Magnétron Sputtering ») dans laquelle la cible est polarisée de manière particulière afin de former un revêtement de nitrure de tantale lequel constitue un matériau satisfaisant pour le remplacement des oxydes de chrome au degré d'oxydation +VI. La polarisation continue permet de maintenir un plasma résiduel lorsque les pulses ne sont pas appliqués, et ainsi de limiter l'énergie supplémentaire à apporter pour initier le plasma permettant de former le revêtement. La polarisation pulsée permet alors une augmentation importante de la réactivité du plasma et ainsi la création d'espèces chargées dans le plasma en un nombre bien supérieur à celui obtenu en l'absence de la polarisation continue. La présence d'un plasma résiduel maintenu par la polarisation continue permet également de diminuer les instabilités électriques susceptibles d'apparaître pendant l'application des pulses. Cela permet de maîtriser finement la microstructure du revêtement de nitrure de tantale obtenu.

Le procédé peut permettre le revêtement d'un substrat par au moins une couche de nitrure de tantale hexagonal ou cubique à faces centrées selon les conditions opératoires choisies.

Dans un mode de réalisation, le substrat est revêtu au moins par du nitrure de tantale hexagonal en imposant à la cible la superposition d'une polarisation continue à un potentiel compris entre -199 V et -100 V et d'une polarisation pulsée dont les pulses ont un potentiel compris entre -900 V et -701 V.

Un tel revêtement de nitrure de tantale hexagonal est particulièrement avantageux dans la mesure où il présente une dureté supérieure à celle des revêtements à base de chrome tout en présentant une bonne résistance à l'oxydation et à la corrosion.

Dans un autre mode de réalisation, le substrat est revêtu au moins par du nitrure de tantale cubique à faces centrées en imposant à la cible la superposition d'une polarisation continue à un potentiel compris entre -300 V et -200 V et d'une polarisation pulsée dont les pulses ont un potentiel compris entre -700 V et -500 V.

Un tel revêtement de nitrure de tantale cubique à faces centrées est particulièrement avantageux dans la mesure où il présente une bonne stabilité chimique et structurale à des températures supérieures à 800°C.

Dans un autre mode de réalisation, le substrat est revêtu par du nitrure de tantale hexagonal en mettant en oeuvre un procédé imposant des conditions de polarisation telles que définies ci-dessus, et par du nitrure de tantale cubique à faces centrées en mettant en oeuvre un procédé imposant des conditions de polarisation telles que définies ci-dessus.

Un tel mode de réalisation peut permettre d'obtenir un revêtement ayant un gradient de microstructure, comprenant à la fois du nitrure de tantale cubique à face centrées et du nitrure de tantale hexagonal. Le revêtement de nitrure de tantale hexagonal peut être déposé sur le revêtement de nitrure de tantale cubique à faces centrées précédemment formé ou, inversement, le revêtement de nitrure de tantale cubique à faces centrées peut être déposé sur le revêtement de nitrure de tantale hexagonal précédemment formé.

En contrôlant ainsi la microstructure du revêtement, il est possible d'adapter au mieux ce dernier aux sollicitations subies afin par exemple d'éviter tout risque de délamination du revêtement et de dévier les fissures éventuellement formées en fonctionnement.

Dans un mode de réalisation, le substrat est polarisé à un potentiel strictement négatif et supérieur ou égal à -200 V.

L'application d'une telle polarisation du substrat permet d'obtenir des couches de nitrure de tantale plus denses.

Dans un mode de réalisation, l'atmosphère est un mélange d'argon et d'azote, la teneur volumique d'azote dans l'atmosphère étant comprise entre 1 % et 30 % et la teneur volumique d'argon dans l'atmosphère étant comprise entre 70 % et 99 %.

L'invention s'applique au revêtement d'une grande diversité de substrats selon l'application visée. Dans un mode de réalisation, le substrat peut être métallique, par exemple être un alliage métallique et notamment un acier.

Dans un autre mode de réalisation, le substrat est un superalliage, par exemple un superalliage de nickel ou de cobalt. Dans un autre mode de réalisation, le substrat est un alliage de titane ou d'aluminium.

Le substrat peut être une pièce d'aéronef, par exemple une pièce de train d'atterrissage d'aéronef ou de turbomachine d'aéronef. Le substrat peut en particulier être une pièce de turbine d'aéronef.

Dans un mode de réalisation particulier, le procédé permet de former un revêtement de nitrure de tantale hexagonal sur un substrat en superalliage.

### Description des figures

**[****Fig. 1****]** La figure 1 décrit schématiquement un dispositif permettant la réalisation d'un exemple de procédé de revêtement selon l'invention.
**[****Fig. 2****]** La figure 2 décrit schématiquement la polarisation de la cible au cours du temps lors d'un procédé de revêtement selon l'invention.
**[****Fig. 3****]** La figure 3 décrit schématiquement un substrat revêtu par mise en oeuvre d'un mode de réalisation de l'invention.
**[****Fig. 4****]** La figure 4 décrit schématiquement un substrat revêtu par mise en oeuvre d'un autre mode de réalisation de l'invention.
**[****Fig. 5****]** La figure 5 est un diffractogramme des rayons X pour des substrats revêtus par différents modes de réalisation de l'invention.

### Description des modes de réalisation

L'invention va à présent être décrite au moyen des figures présentes à titre illustratif et ne devant pas être interprétées comme limitant la portée de l'invention.

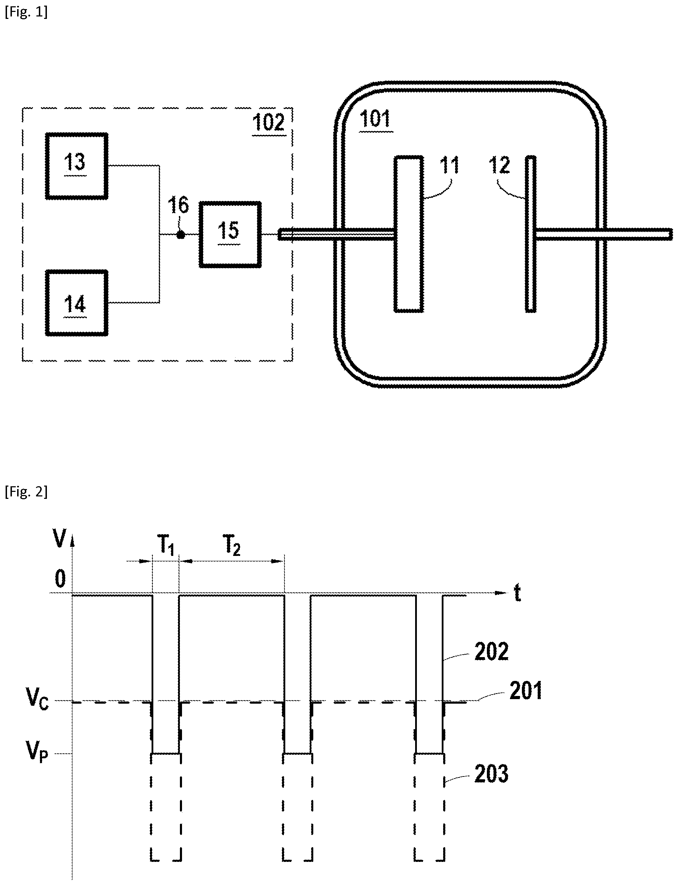

La figure 1 représente schématiquement un dispositif permettant de réaliser un dépôt par pulvérisation cathodique magnétron pulsé à haute puissance selon un mode de réalisation de l'invention.

Le dispositif comprend une chambre 101 destinée à recevoir un gaz plasmagène, par exemple constitué d'un mélange d'argon et d'azote. Le dispositif comprend en outre une source de gaz plasmagène (non représentée) en communication avec la chambre 101.

La chambre 101 comprend une cible 11 de tantale constituant la cathode et un substrat 12 à recouvrir constituant l'anode. Dans un mode de réalisation, la cible 11 comprend du tantale à raison de plus de 99 % en pourcentages atomiques, et de préférence à raison de plus de 99,9 % en pourcentages atomiques. Le substrat 12 à revêtir est conducteur de l'électricité et sa nature peut varier selon l'application recherchée comme indiqué plus haut.

Durant le revêtement, la cible 11 est polarisée comme décrit plus haut en superposant une polarisation continue et une polarisation pulsée. La polarisation de la cible 11 est imposée par l'ensemble d'alimentation électrique 102. L'ensemble d'alimentation électrique 102 comprend un générateur de pulses de tension 13 et un générateur de tension continue 14 connectés électriquement à la cible 11. Le générateur de pulses de tension 13 permet d'imposer la polarisation pulsée à la cible 11. Le générateur de tension continue 14 permet d'imposer la polarisation continue à la cible 11. Cet ensemble 102 peut également comprendre un organe de mesure du courant 16 connecté à un dispositif de coupure du courant 15. Pendant l'utilisation, si la valeur du courant mesurée par l'organe de mesure du courant 16 est supérieure à une valeur seuil, le dispositif de coupure du courant 15 est configuré pour couper l'alimentation de la cible 11 et arrêter ainsi le procédé. L'association de l'organe de mesure du courant 16 et du dispositif de coupure du courant 15 permet de prévenir tout risque d'endommagement du revêtement ou du dispositif du fait de la création d'un arc électrique dans la chambre 101. Une telle association d'éléments 15 et 16 est connue en soi.

Dans la chambre 101, l'application d'une tension entre la cible 11 et le substrat 12 en présence d'une atmosphère comprenant de l'azote permet de créer un plasma. Des électrons sont générés par la cible 11 et peuvent ioniser par collision les atomes constitutifs du plasma. Il est possible d'introduire dans la chambre 101 à proximité de la cible 11 un ou plusieurs aimants permanents, non représentés, dont le champ magnétique confine les électrons générés à proximité de la cible 11 et augmente la probabilité que la collision entre un électron et un atome du plasma y ait lieu. Lorsqu'une telle collision a lieu, une espèce de haute énergie est générée, et cette dernière peut venir bombarder la cible 11 et arracher, par choc élastique, des particules de la cible 11. Les particules de la cible 11 ainsi arrachées peuvent alors se déposer sur le substrat 12 pour former le revêtement.

Le revêtement peut être réalisé sous vide, par exemple à une pression dans la chambre 101 inférieure ou égale à 2 Pa, par exemple comprise entre 0,5 Pa et 2 Pa.

Le substrat peut être chauffé durant le revêtement par un organe de chauffage non représenté. En variante, le substrat peut ne pas être chauffé durant le revêtement. La température du substrat peut par exemple être supérieure ou égale à 20°C durant le revêtement, par exemple comprise entre 20°C et 600 °C, voire comprise entre 30°C et 500°C.

La température permet d'apporter au substrat de l'énergie thermique, et ainsi de permettre une certaine mobilité des atomes favorisant la recombinaison des atomes se déposant à la surface du substrat.

La figure 2 représente la polarisation 203 imposée à la cible au cours du temps. Comme figuré, la polarisation 203 imposée à la cible correspond à la superposition d'une polarisation continue 201 de valeur Vc, et d'une polarisation pulsée 202 ayant des pulses au potentiel Vp.

La polarisation pulsée 202 est caractérisée par le potentiel de ses pulses Vp, la durée des pulses T1, et la durée T2 pendant laquelle aucun pulse n'est appliqué correspondant à la durée entre deux pulses consécutifs. La polarisation pulsée 202 comprend une succession de pulses alternant avec des phases de non-application des pulses. Chaque pulse présente un palier à un potentiel Vp compris entre -1200 V et -400 V. La durée T1 de chaque pulse peut être comprise entre 5 µs et 50 µs. La polarisation pulsée 202 peut être périodique, par exemple avec une fréquence de pulses comprise entre 50 Hz et 500 Hz. Le rapport cyclique de la polarisation pulsée, correspondant au rapport entre la durée des pulses et la période de la polarisation pulsée, soit en l'espèce T1/(T1+T2) peut être compris entre 1% et 50%.

On a représenté une forme de pulses en créneau mais ces derniers pourrait en variante avoir une forme de pic avec un sommet à un potentiel compris entre -1200 V et -400 V.

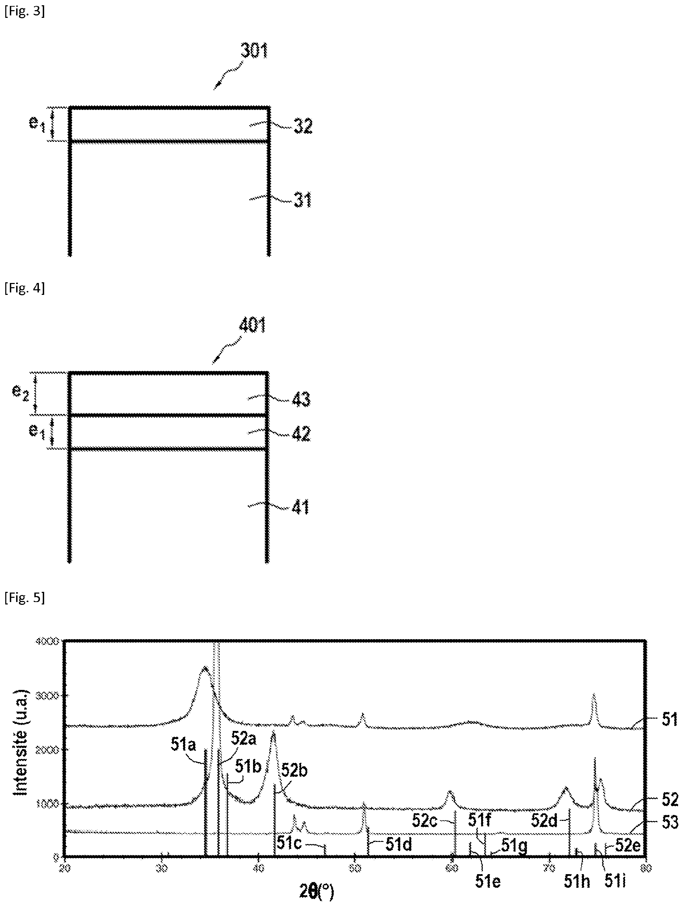

La figure 3 représente un ensemble 301 comportant un substrat 31 revêtu d'un revêtement 32 d'épaisseur e1 obtenu par un mode de réalisation du procédé. Le revêtement 32 peut être soit du nitrure de tantale hexagonal, soit du nitrure de tantale cubique à faces centrées selon les polarisations choisies pour la polarisation pulsée et la polarisation continue. L'épaisseur e1 du revêtement 32 est contrôlée par la durée du dépôt. Le revêtement de nitrure de tantale 32 peut être déposé au contact du substrat 31.

Par exemple, l'épaisseur e1 du revêtement 32 de nitrure de tantale obtenu peut être comprise entre 1 nm et 50 µm. La durée durant laquelle le substrat 31 est revêtu peut être comprise entre 5 secondes et 100 heures.

La figure 4 représente un ensemble 401 comportant un substrat 41 revêtu d'un premier revêtement 42 d'épaisseur e1 et d'un deuxième revêtement 43 d'épaisseur e2 obtenu en faisant varier au cours du dépôt les valeurs de la polarisation imposée à la cible entre celles permettant un dépôt de nitrure de tantale hexagonal et celles permettant dépôt de nitrure de tantale cubique à faces centrées ou vice versa. Ainsi, il est possible d'obtenir à la surface d'un substrat 41 un revêtement comprenant une première couche 42 de nitrure de tantale hexagonal ou cubique à faces centrées, et une deuxième couche 43 de nitrure de tantale cubique à faces centrées ou hexagonal différente de la première couche 42 et recouvrant la première couche 42. La première couche 42 peut être déposée au contact du substrat 41. La deuxième couche 43 peut être déposée au contact de la première couche 42.

Les épaisseurs e1 et e2 du premier et du deuxième revêtement 42, 43 peuvent être identiques ou différentes. Comme indiqué précédemment, les épaisseurs sont contrôlées par la durée du procédé de dépôt.

On ne vient de décrire qu'une seule variation des conditions de polarisation permettant un revêtement avec une première et une seconde couches de nitrure de tantale, mais les modes de réalisation comprenant plusieurs variations des conditions de polarisation doivent être considérés comme faisant partie de l'invention. On peut ainsi obtenir un revêtement de nitrure de tantale multicouches à plus de deux couches avec variation de la microstructure du nitrure de tantale entre les différentes couches.

La figure 5 est un diffractogramme obtenu par diffraction des rayons X de deux substrats revêtus obtenus par l'invention 51 et 52.

Les diffractogrammes 51 et 52 ont été obtenus pour des dépôts réalisés sur un substrat en acier sous une pression de 2 Pa et dans une atmosphère dont la composition comprend 10 % volumique de diazote et 90 % volumique d'argon.

Le diffractogramme 51 est obtenu pour un dépôt réalisé sur un substrat en acier, en imposant à la cible la superposition d'une polarisation continue à un potentiel de - 250 V et d'une polarisation pulsée dont les pulses ont un potentiel de -620 V, une durée de 40 µs et une fréquence de 1200 Hz. La puissance de la cathode magnétron est de 16 W, la température du substrat est de 400°C, et une polarisation continue de -150 V est appliquée au substrat.

Le diffractogramme 52 est obtenu pour un dépôt réalisé en imposant à la cible la superposition d'une polarisation continue à un potentiel de -150 V d'une polarisation pulsée dont les pulses ont un potentiel de -800 V, une durée de 40 µs et une fréquence de 1200 Hz. La puissance de la cathode magnétron est de 59 W, la température du substrat est de 400°C, et aucune polarisation continue n'est appliquée au substrat.

Sont également représentés les pics théoriques de diffraction du nitrure de tantale cubique à faces centrées 51a - 51i et les pics théoriques de diffraction du nitrure de tantale hexagonal 52a - 52e.

Est également présent en figure 5, le diffractogramme 53 obtenu pour un acier identique à celui utilisé comme substrat pour les revêtements caractérisés aux diffractogrammes 51 et 52.

Les diffractogrammes des substrats revêtus 51 et 52 font bien apparaître respectivement les pics caractéristiques du nitrure de tantale cubique à faces centrées et du nitrure de tantale hexagonal, confirmant que les paramètres décrits ci-dessus permettent bien l'obtention sélective des revêtements décrits.

L'expression « compris(e) entre ... et ... » doit se comprendre comme incluant les bornes.

## Revendications

1. Procédé de revêtement d'un substrat (12) par du nitrure de tantale par technique de pulvérisation cathodique magnétron pulsé à haute puissance, dans lequel on utilise une cible (11) de tantale et dans lequel le revêtement du substrat est effectué sous atmosphère contenant de l'azote, **caractérisé en ce que** la polarisation de la cible est contrôlée durant le revêtement en imposant à celle-ci la superposition d'une polarisation continue à un potentiel (Vc) compris entre -300 V et -100 V et d'une polarisation pulsée dont les pulses ont un potentiel (Vp) compris entre -1200 V et -400 V.

2. Procédé de revêtement selon la revendication 1, dans lequel le substrat (12) est revêtu au moins par du nitrure de tantale hexagonal en imposant à la cible (11) la superposition d'une polarisation continue (Vc) à un potentiel compris entre -199 V et -100 V et d'une polarisation pulsée dont les pulses ont un potentiel (Vp) compris entre -900 V et -701 V.

3. Procédé de revêtement selon la revendication 1, dans lequel le substrat (12) est revêtu au moins par du nitrure de tantale cubique à faces centrées en imposant à la cible (11) la superposition d'une polarisation continue (Vc) à un potentiel compris entre -300 V et -200 V et d'une polarisation pulsée dont les pulses ont un potentiel (Vp) compris entre -700 V et -500 V.

4. Procédé de revêtement selon la revendication 1, dans lequel le substrat (12) est revêtu par du nitrure de tantale hexagonal en imposant à la cible (11) la superposition d'une polarisation continue (Vc) à un potentiel compris entre -199 V et -100 V et d'une polarisation pulsée dont les pulses ont un potentiel (Vp) compris entre -900 V et -701 V, et par du nitrure de tantale cubique à faces centrées en imposant à la cible la superposition d'une polarisation continue (Vc) à un potentiel compris entre -300 V et -200 V et d'une polarisation pulsée dont les pulses ont un potentiel (Vp) compris entre -700 V et -500 V.

5. Procédé de revêtement selon l'une quelconque des revendications 1 à 4, dans lequel le substrat (12) est polarisé à un potentiel strictement négatif et supérieur ou égal à -200 V.

6. Procédé de revêtement selon l'une quelconque des revendications 1 à 5, dans lequel le substrat (12) est métallique.

7. Procédé de revêtement selon la revendication 6, dans lequel le substrat (12) est un acier.

8. Procédé selon l'une quelconque des revendications 1 à 7, dans lequel le substrat (12) est une pièce d'aéronef

9. Procédé de revêtement selon l'une quelconque des revendications 1 à 8, dans lequel l'atmosphère est un mélange d'argon et d'azote, la teneur volumique d'azote dans l'atmosphère étant comprise entre 1 % et 30 % et la teneur volumique d'argon dans l'atmosphère étant comprise entre 70 % et 99 %.

## Patentansprüche

1. Verfahren zur Beschichtung eines Substrats (12) mit Tantalnitrid durch die Technik der gepulsten Hochleistungs-Magnetron-Kathodenzerstäubung, wobei ein Tantaltarget (11) verwendet wird und wobei die Beschichtung des Substrats in einer Atmosphäre durchgeführt wird, die Stickstoff enthält, **dadurch gekennzeichnet, dass** die Polarisierung des Targets während der Beschichtung gesteuert wird, indem dieses der Überlagerung durch eine kontinuierliche Polarisierung mit einem Potential (Vc) zwischen -300 V und -100 V und eine gepulste Polarisierung unterzogen wird, deren Pulse ein Potential (Vp) zwischen -1200 V und - 400 V haben.

2. Beschichtungsverfahren nach Anspruch 1, wobei das Substrat (12) mit mindestens hexagonalem Tantalnitrid beschichtet wird, indem das Target (11) der Überlagerung durch eine kontinuierliche Polarisierung (Vc) mit einem Potential unterzogen wird, das zwischen -199 V und -100 V liegt, und eine gepulste Polarisierung, deren Pulse ein Potential (Vp) zwischen -900 V und -701 V haben.

3. Beschichtungsverfahren nach Anspruch 1, wobei das Substrat (12) mit mindestens kubischem Tantalnitrid mit zentrierten Flächen beschichtet wird, indem das Target (11) der Überlagerung durch eine kontinuierliche Polarisierung (Vc) mit einem Potential unterzogen wird, das zwischen -300 V und -200 V liegt, und eine gepulste Polarisierung, deren Pulse ein Potential (Vp) zwischen -700 V und -500 V haben.

4. Beschichtungsverfahren nach Anspruch 1, wobei das Substrat (12) mit hexagonalem Tantalnitrid beschichtet wird, indem das Target (11) der Überlagerung durch eine kontinuierliche Polarisierung (Vc) mit einem Potential unterzogen wird, das zwischen -199 V und -100 V liegt, und eine gepulste Polarisierung, deren Pulse ein Potential (Vp) zwischen - 900 V und -701 V haben, und mit kubischem Tantalnitrid mit zentrierten Flächen, indem das Target der Überlagerung durch eine kontinuierliche Polarisierung (Vc) mit einem Potential unterzogen wird, das zwischen -300 V und -200 V liegt, und eine gepulste Polarisierung, deren Pulse ein Potential (Vp) zwischen -700 V und -500 V haben.

5. Beschichtungsverfahren nach einem der Ansprüche 1 bis 4, wobei das Substrat (12) mit einem Potential strikt negativ und über oder gleich -200 V polarisiert wird.

6. Beschichtungsverfahren nach einem der Ansprüche 1 bis 5, wobei das Substrat (12) metallisch ist.

7. Beschichtungsverfahren nach Anspruch 6, wobei das Substrat (12) ein Stahl ist.

8. Verfahren nach einem der Ansprüche 1 bis 7, wobei das Substrat (12) ein Flugzeugteil ist.

9. Beschichtungsverfahren nach einem der Ansprüche 1 bis 8, wobei die Atmosphäre ein Gemisch aus Argon und Stickstoff ist, wobei der Volumengehalt von Stickstoff in der Atmosphäre zwischen 1% und 30% liegt und der Volumengehalt von Argon in der Atmosphäre zwischen 70% und 99% liegt.

## Claims

1. A process for coating a substrate (12) with tantalum nitride by the high-power impulse magnetron sputtering technique, wherein a tantalum target (11) is used and in which the coating of the substrate is carried out in an atmosphere containing nitrogen, the bias of the target being controlled during the coating by imposing on it the superposition of a continuous bias at a potential (Vc) comprised between -300 V and -100 V and of a pulsed bias whose pulses have a potential (Vp) comprised between -1200 V and -400 V.

2. Coating process as claimed in claim 1, wherein the substrate (12) is coated with at least hexagonal tantalum nitride by imposing on the target (11) the superposition of a continuous bias (Vc) at a potential comprised between -199 V and -100 V and of a pulsed bias whose pulses have a potential (Vp) comprised between -900 V and -701 V.

3. The coating process as claimed in claim 1, wherein the substrate (12) is coated with at least face-centered cubic tantalum nitride by imposing on the target (11) the superposition of a continuous bias (Vc) at a potential comprised between -300 V and -200 V and of a pulsed bias whose pulses have a potential (Vp) comprised between -700 V and -500 V.

4. The coating process as claimed in claim 1, wherein the substrate (12) is coated with hexagonal tantalum nitride by imposing on the target (11) the superposition of a continuous bias (Vc) at a potential comprised between -199 V and -100 V and of a pulsed bias whose pulses have a potential (Vp) comprised between -900 V and -701 V, and by face-centered cubic tantalum nitride by imposing on the target the superposition of a continuous bias (Vc) at a potential comprised between -300 V and -200 V and of a pulsed bias whose pulses have a potential (Vp) comprised between -700 V and -500 V.

5. The coating process as claimed in any one of claims 1 to 4, wherein the substrate (12) is biased at a strictly negative potential greater than or equal to -200 V.

6. The coating process as claimed in any one of claims 1 to 5, wherein the substrate (12) is metallic.

7. The coating process as claimed in claim 6, wherein the substrate (12) is a steel.

8. The process as claimed in any one of claims 1 to 7, wherein the substrate (12) is an aircraft component.

9. The coating process as claimed in any one of claims 1 to 8, wherein the atmosphere is a mixture of argon and nitrogen, the nitrogen content by volume in the atmosphere being comprised between 1% and 30% and the argon content by volume in the atmosphere being comprised between 70% and 99%.
